Europäisches Patentamt

European Patent Office

Office européen des brevets

(11) Veröffentlichungsnummer: **0 497 117 A1**

# EUROPÄISCHE PATENTANMELDUNG

(21) Anmeldenummer: **92100372.9**

(22) Anmeldetag: **11.01.92**

(51) Int. Cl.5: **H03K 5/08**

(30) Priorität: **29.01.91 DE 4102519**

(43) Veröffentlichungstag der Anmeldung:
**05.08.92 Patentblatt 92/32**

(84) Benannte Vertragsstaaten:
**AT DE ES FR GB IT PT**

(71) Anmelder: **Blaupunkt-Werke GmbH**
**Robert-Bosch-Strasse 200**
**W-3200 Hildesheim(DE)**

(72) Erfinder: **Hegeler, Wilhelm**
**Knollenstrasse 11**
**W-3200 Hildesheim(DE)**
Erfinder: **Kässer, Jürgen, Dr.**
**Ahornweg 5**
**W-3201 Diekholzen(DE)**

(74) Vertreter: **Eilers, Norbert, Dipl.-Phys.**
**Blaupunkt-Werke GmbH**
**Robert-Bosch-Strasse 200**
**W-3200 Hildesheim(DE)**

(54) Schaltungsanordnung zur Ableitung eines Binärsignals aus einer Wechselspannung.

(57) Bei einer Schaltungsanordnung zur Ableitung eines Binärsignals aus einer Wechselspannung, wobei die Wechselspannung über einen Kondensator dem Eingang einer Schwellwertschaltung zuführbar ist und zur Arbeitspunkteinstellung am Eingang eine durch Integration gewonnene Referenzspannung dient, ist zur Ableitung der Referenzspannung ein Aufwärts/Abwärts-Zähler vorgesehen, dessen Zählrichtung von dem Binärsignal steuerbar ist. Aus dem Ausgangssignal des Aufwärts/Abwärts-Zählers wird ein weiteres Binärsignal abgeleitet, das nach Integration die Referenzspannung bildet.

Fig. 1

EP 0 497 117 A1

Die Erfindung geht aus von einer Schaltungsanordnung nach der Gattung des Hauptanspruchs.

Für Zwecke einer digitalen Signalverarbeitung werden häufig Schaltungsanordnungen benötigt, welche aus einer zugeführten Wechselspannung ein binäres Signal erzeugen, das heißt ein Signal mit zwei möglichen Spannungswerten, dessen Flanken im wesentlichen bei den Nulldurchgängen der Wechselspannung liegen. Das Tastverhältnis beträgt dann bei sinusförmiger Wechselspannung etwa 50%.

Bei bekannten Schaltungen wird dazu die Wechselspannung über einen Kondensator dem Eingang eines als Schwellwertschaltung ausgebildeten Verstärkers zugeführt. Zur Regelung des Schwellwertes in Bezug auf den Amplitudenbereich der Wechselspannung wird bei Schaltungsanordnungen dieser Art mit einem an sich für digitale Schaltungen vorgesehenen Inverter das Ausgangssignal des Inverters über eine Schaltung zur Mittelwertbildung - vorzugsweise ein RC-Glied mit geeigneter Zeitkonstante - an den Eingang des Inverters zurückgeführt, was eine entsprechende Regelung des Arbeitspunktes am Eingang des Inverters bewirkt. Bei einer besonders einfachen bekannten Schaltung wird der für die Wechselspannung vorgesehene Koppelkondensator gleichzeitig als Kondensator zur Bildung des Mittelwertes benutzt. Diese bekannte Schaltungsanordnung hat jedoch den Nachteil, daß eine vom Mittelwert abweichende Eingangschaltschwelle ein im Mittel unsymmetrisches Ausgangssignal zur Folge hat: Das Tastverhältnis des Ausgangssignals läuft von 0% bis 100%, wenn die Schaltschwelle von 0 bis zur Versorgungsspannung variiert.

Ein weiterer Nachteil liegt darin, daß bei einer nicht ausreichend hohen Zeitkonstante des RC-Gliedes eine dreieckförmige Spannung mit der Frequenz der Ein- bzw. Ausgangsspannung auf den Eingang gekoppelt wird und dadurch die Schaltung bei zu kleinen Eingangssignalen auf ihrer Eigenfrequenz schwingt, während bei etwas größeren Eingangssignalen starke Phasenverschiebungen auftreten können. Eine beliebige Vergrößerung der Zeitkonstante ist jedoch aus Gründen der Regelgeschwindigkeit und des Aufwands häufig nicht möglich.

Aufgabe der Erfindung ist es, eine Schaltungsanordnung zur Ableitung eines Binärsignals aus einer Wechselspannung vorzuschlagen, bei welcher diese Nachteile weitgehend vermieden werden. Insbesondere soll die erfindungsgemäße Schaltungsanordnung noch bei stark schwankenden Amplituden der Wechselspannung arbeiten, wie sie beispielsweise bei einem Hilfsträger für ein Radio-Daten-Signal (RDS) auftreten.

Die erfindungsgemäße Schaltungsanordnung mit den kennzeichnenden Merkmalen des Hauptanspruchs hat den Vorteil, daß eine einwandfreie Ableitung eines Binärsignals auch bei geringen bzw. wechselnden Amplituden der Wechselspannung möglich ist. Der zusätzliche Aufwand gegenüber den bekannten Schaltungen liegt allein im Bereich des Digitalen, wo er bei dem heutigen Stand der Technik integrierter Schaltungen kaum ins Gewicht fällt.

Durch die in den Unteransprüchen aufgeführten Maßnahmen sind vorteilhafte Weiterbildungen und Verbesserungen der im Hauptanspruch angegebenen Erfindung möglich.

Ausführungsbeispiele der Erfindung sind in der Zeichnung anhand mehrerer Figuren dargestellt und in der nachfolgenden Beschreibung näher erläutert. Es zeigt:

Fig. 1    ein Blockschaltbild eines ersten Ausführungsbeispiels,

Fig. 2    Zeitdiagramme der bei der Schaltungsanordnung nach Fig. 1 auftretenden Signale,

Fig. 3    ein zweites Ausführungsbeispiel und

Fig. 4    ein drittes Ausführungsbeispiel.

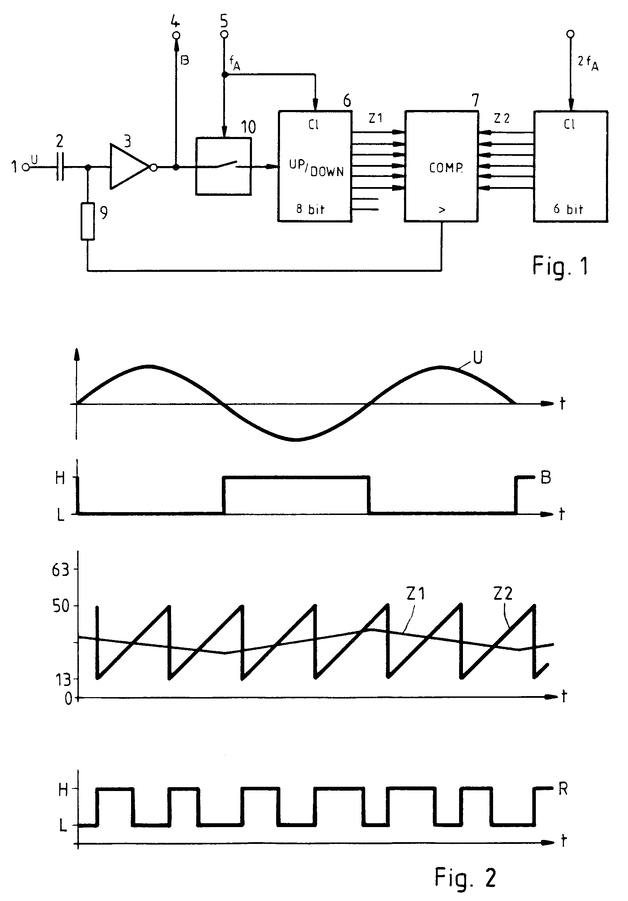

Gleiche Teile sind in den Figuren mit gleichen Bezugszeichen versehen. Außerdem wurden die in Fig. 2 dargestellten Signale gleichlautend mit den entsprechenden Punkten der Schaltungsanordnung nach Fig. 1 bezeichnet.

Bei der Schaltungsanordnung nach Fig. 1 wird die Wechselspannung über einen Eingang 1 und einen Koppelkondensator 2 dem Eingang eines Inverters 3 zugeführt. Der Ausgang des Inverters stellt einerseits den Ausgang 4 der Schaltungsanordnung dar und ist andererseits mit einer Taststufe 10 verbunden, welche mit einer Abtastfrequenz $f_A$ gesteuert wird, die an einen weiteren Eingang 5 angelegt wird. Das somit getaktete Binärsignal steuert die Zählrichtung eines Aufwärts/Abwärts-Zählers 6, der ebenfalls mit $f_A$ getaktet wird.

Der Aufwärts/Abwärts-Zähler 6 hat eine Kapazität von acht Binärstellen, von denen allerdings nur die sechs höchstwertigen Binärstellen als Signal Z2 ausgewertet werden. Dazu sind die entsprechenden Ausgänge mit Eingängen eines Komparators 7 verbunden, dessen weitere Eingänge an Ausgänge eines weiteren Zählers 8 angeschlossen sind, der mit der doppelten Abtastfrequenz $f_A$ getaktet wird. Der weitere Zähler 8 ist ein 6-Bit-Zähler, welcher derart betrieben wird, daß sein Zählerstand einen mittleren Wertebereich von beispielsweise 13 bis 50 durchläuft. Dazu sind in an sich bekannter Weise über nicht dargestellte Logikschaltungen geeignete Rückführungen vorgesehen, welche den Zähler auf 13 setzen, wenn der Zählerstand den Wert 50 erreicht hat.

Der Komparator 7 gibt ein Signal mit dem logischen Pegel H ab, wenn der Zählerstand des Aufwärts/Abwärts-Zählers 6 größer als der Zählerstand des weiteren Zählers 8 ist. Dieses Signal wird über einen Widerstand 9 an den Eingang des Inverters 3 geleitet. Der Widerstand 9 bildet zusammen mit dem Koppelkondensator 2 einen Integrator bzw. eine Schaltung zur Bildung des Mittelwertes, wobei vorausgesetzt wird, daß der Quellwiderstand der an den Eingang 1 angeschlossenen Wechselspannungsquelle klein gegenüber dem Widerstand 9 ist.

Im folgenden wird die Wirkungsweise der Schaltungsanordnung nach Fig. 1 anhand der in Fig. 2 dargestellten Diagramme näher erläutert. Die Wechselspannung U ist beispielsweise ein Hilfsträger für ein Radio-Daten-Signal mit einer Frequenz von 57 kHz. Mit Hilfe der Schaltungsanordnung nach Fig. 1 wird daraus ein Binärsignal B abgeleitet, dessen Flanken im wesentlichen mit den Nulldurchgängen der Wechselspannung U übereinstimmen.

Der Aufwärts/Abwärts-Zähler 6 zählt aufwärts, wenn das Signal B den Pegel H einnimmt, während der Pegel L des Signals B ein Abwärtszählen des Aufwärts/Abwärts-Zählers 6 bewirkt. In Form einer Dreiecksfunktion folgt daher der Zählerstand Z1 des Aufwärts/Abwärts-Zählers 6 dem Binärsignal B, wobei sich bei einem Tastverhältnis von 50% das Aufwärts- und das Abwärtszählen die Waage halten. Überwiegt jedoch bei dem Binärsignal B die Dauer des Pegels H, so wird Z1 allmählich größer, während bei einem Überwiegen der Dauer des Pegels L Z1 kleiner wird. Der Aufwärts/Abwärts-Zähler 6 ist mit einer Überlaufsperre versehen, die bewirkt, daß bei Erreichen des maximalen Zählerstandes und des minimalen Zählerstandes bei weiterem Auf- bzw. Abwärtszählen der maximale bzw. minimale Zählerstand erhaltenbleibt.

Bei der Auswertung eines Hilfsträgers eines Radio-Daten-Signals beträgt die Frequenz der Signale U und B 57 kHz, während der Aufwärts/Abwärts-Zähler 6 vorzugsweise mit einer Frequenz von 4,332 MHz getaktet wird. Innerhalb einer Halbwelle der Signale U bzw. B wird der Aufwärts/Abwärts-Zähler 6 dementsprechend um 38 aufwärts- bzw. abwärts gezählt. Durch die Nichtberücksichtigung der beiden geringstwertigen Binärstellen des Zählerstands ergibt sich eine Schwankung des Signals Z1 um 38/4 bei einem Tastverhältnis von 50%. Ändert sich das Tastverhältnis, so überwiegt das Aufwärts- oder das Abwärtszählen, so daß der Zählerstand sich entsprechend ändert.

Durch den Vergleich des Signals Z1 mit dem Signal Z2, welches den Wertebereich zwischen 13 und 50 durchläuft, ergibt sich das ebenfalls in Fig. 2 dargestellte Binärsignal R. Dieses nimmt den Pegel H ein, wenn das Signal Z1 größer als das Signal Z2 ist. Ansonsten verbleibt das Signal R bei L.

Durch das RC-Glied 9, 2 wird aus dem Signal R der Mittelwert gebildet und dem Eingang des Inverters 11 zugeführt. Der Mittelwert des Signals R wird umso größer, je länger das Signal Z1 größer als das Signal Z2 ist. Durch die Verschiebung des Eingangssignals des Inverters 3 in positive Richtung, wird jedoch das Tastverhältnis des Binärsignals B kleiner, das heißt, es verbleibt länger bei dem Pegel L als beim Pegel H. Dieses führt dazu, daß der mittlere Zählerstand des Aufwärts/Abwärts-Zählers 6 kleiner wird, was über eine Verringerung des Mittelwertes des Binärsignals R der Verkleinerung des Tastverhältnisses des Binärsignals B entgegenwirkt.

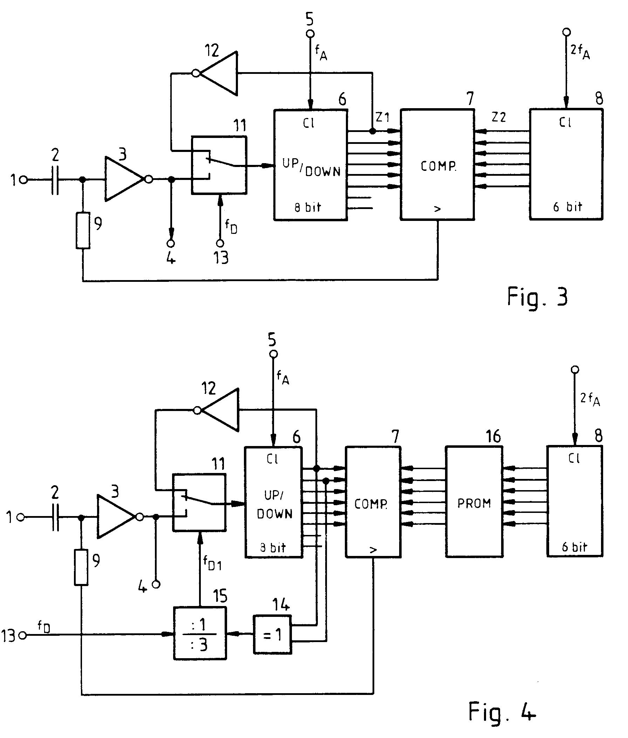

Das Ausführungsbeispiel nach Fig. 3 gleicht mit seinen wesentlichen Bestandteilen demjenigen nach Fig. 1. Zur Bedämpfung möglicherweise auftretender Regelschwingungen wird jedoch der als Integrator wirksame Aufwärts/Abwärts-Zähler 6 bei dem Ausführungsbeispiel nach Fig. 3 dadurch bedämpft, daß er in regelmäßigen Zeitabständen um einen Zählschritt in Richtung auf die Mitte seines Wertebereichs bewegt wird. Dazu ist ein Multiplexer 11 vorgesehen, der mit einem Taktsignal der Frequenz $f_D$ kurzzeitig, beispielsweise für jeweils eine Taktperiode, in die obere Stellung bewegt wird. Während dieser Zeit wird die über einen weiteren Inverter 12 geleitete höchstwertige Binärstelle des Signals Z1 zum Aufwärts/Abwärts-Eingang des Aufwärts/Abwärts-Zählers 6 geleitet. Da bei einer Binärcodierung die höchstwertige Binärstelle in der unteren Hälfte des Wertebereichs 0 und in der oberen Hälfte 1 ist, wird der Zählerstand inkrementiert, wenn der Zähler sich in der unteren Hälfte befindet, und in der oberen Hälfte dekrementiert. Dadurch ergibt sich eine Tendenz zur Mitte des Wertebereichs, die den Regelkreis bedämpft.

Anhand des Ausführungsbeispiels nach Fig. 4 werden zwei weitere Verbesserungen der erfindungsgemäßen Schaltungsanordnung erläutert. Im übrigen entspricht die Schaltungsanordnung nach Fig. 4 derjenigen nach Fig. 3.

Zum einen wird bei dem Ausführungsbeispiel nach Fig. 4 eine gleichmäßigere Bedämpfung über den Wertebereich dadurch möglich, daß die Häufigkeit, mit welcher der Aufwärts/Abwärts-Zähler 6 in Richtung auf die Mitte des Wertebereichs gesteuert wird, vom Zählerstand abhängig ist. Dazu werden die beiden höchstwertigen Binärstellen von Z1 über eine Exklusiv-Oder-Schaltung 14 einem steuerbaren Frequenzteiler 15 zugeführt, der die Frequenz $f_D$ des bei 13 anliegenden Taktsignals entweder nicht verändert oder durch 3 teilt. Dadurch wird die Frequenz $f_{D1}$, mit welcher der Multiplexer 11 betrieben wird, derart gesteuert, daß sie an den Rändern des Wertebereichs höher als in der Mitte ist, was in der folgenden Tabelle dargestellt ist.

| MSB | XOR | $f_{D1}$ | Signum |
|-----|-----|----------|--------|
| 1 1 | 0 | 228 kHz | - |
| 1 0 | 1 | 228/3 kHz | - |
| 0 1 | 1 | 228/3 kHz | + |
| 0 0 | 0 | 228 kHz | + |

In der Tabelle bedeutet MSB die beiden höchstwertigen Binärstellen, XOR das Ausgangssignal der Exklusiv-Oder-Schaltung 14, $f_{D1}$ die Frequenz, mit welcher der Multiplexer 11 betrieben wird, und Signum die Richtung, in welcher der Aufwärts/Abwärts-Zähler 6 mit der Häufigkeit $f_{D1}$ gesteuert wird.

Es ergeben sich drei gleichhohe Stufen von je (2/3)•228 kHz, wodurch Regelschwingungen gedämpft werden, solange der Zählerstand infolge des Verhaltens des Eingangssignals eine dieser Grenzen oder die Grenzen des gesamten Wertebereichs passiert bzw. berührt. Im Rahmen der Erfindung ist auch eine feinere Unterteilung denkbar, bei welcher zusätzlich zu den zwei höchstwertigen Bits bei dem Ausführungsbeispiel nach Fig. 4 auch weitere Binärstellen ausgewertet werden können.

Wie aus Fig. 2 ersichtlich ist, befindet sich im Signal Z1 und damit auch im Signal R eine Komponente mit der Frequenz des Eingangssignals U. Da das RC-Glied 9, 2 aus Gründen der Regelgeschwindigkeit nicht mit einer beliebig großen Zeitkonstante versehen werden kann, verbleibt auch in dem auf den Eingang des Inverters 3 zurückgekoppelten Signal eine derartige Komponente. Dieses kann ebenfalls zu Schwingneigungen führen.

Zur Abschwächung dieser Komponente ist bei dem Ausführungsbeispiel nach Fig. 4 vorgesehen, daß das Vergleichssignal Z2 die Werte des mittleren Teils des Wertebereichs nicht ihrer Reihenfolge nach enthält. Dazu ist ein programmierbarer Nur-Lese-Speicher (PROM) 16 vorgesehen, der jedem der Werte des Zählers 8 einen anderen Wert zuordnet. Das Signal Z3, das bei dem Ausführungsbeispiel nach Fig. 4 dem Komparator 7 Zugeführt wird, enthält dann die gleichen Zahlenwerte wie das Signal Z2, jedoch in einer anderen Reihenfolge. Das Signal Z3 weist somit nicht die in Fig. 2 dargestellte Sägezahnform des Signals Z2 auf, sondern nimmt in einer quasi zufälligen Folge alle Werte des mittleren Teils des Wertebereichs ein. Dadurch wird das Ausgangssignal des Komparators in viele kürzere Impulse aufgeteilt, die quasi zufällig verteilt den gesamten Bereich jeweils einer Periode einnehmen. An dem Mittelwert des Signals R ändert sich jedoch nichts.

**Patentansprüche**

1. Schaltungsanordnung zur Ableitung eines Binärsignals aus einer Wechselspannung, wobei die Wechselspannung über einen Kondensator dem Eingang einer Schwellwertschaltung zuführbar ist und zur Arbeitspunkteinstellung am Eingang eine durch Integration gewonnene Referenzspannung dient, dadurch gekennzeichnet, daß zur Ableitung der Referenzspannung ein Aufwärts/Abwärts-Zähler (6) vorgesehen ist, dessen Zählrichtung von dem Binärsignal steuerbar ist, und daß aus dem Ausgangssignal des Aufwärts/Abwärts-Zählers (6) ein weiteres Binärsignal abgeleitet wird, das nach Integration die Referenzspannung bildet.

2. Schaltungsanordnung nach Anspruch 1, dadurch gekennzeichnet, daß das weitere Binärsignal durch einen Vergleich des Ausgangssignals des Aufwärts/Abwärts-Zählers (6) mit einem Vergleichssignal abgeleitet wird.

3. Schaltungsanordnung nach Anspruch 2, dadurch gekennzeichnet, daß das Vergleichssignal ein digitales Signal ist, das periodisch einen mittleren Teil des Wertebereichs des zu vergleichenden Ausgangssignals des Aufwärts/Abwärts-Zählers (6) durchläuft.

4. Schaltungsanordnung nach Anspruch 3, dadurch gekennzeichnet, daß das Vergleichssignal die Werte des mittleren Teils des Wertebereichs nicht ihrer Reihenfolge nach enthält.

5. Schaltungsanordnung nach Anspruch 3, dadurch gekennzeichnet, daß zur Erzeugung des Vergleichssignals ein weiterer Zähler (8) vorgesehen ist.

6. Schaltungsanordnung nach Anspruch 5, dadurch gekennzeichnet, daß dem Aufwärts/Abwärts-Zähler (6) und dem weiteren Zähler (8) zugeführte Taktsignale verkoppelt sind.

7. Schaltungsanordnung nach einem der vorhergehenden Ansprüche, dadurch gekennzeichnet, daß der Aufwärts/Abwärts-Zähler (6) von Zeit zu Zeit kurzzeitig in Richtung auf die Mitte des Wertebereichs gesteuert wird.

8. Schaltungsanordnung nach Anspruch 7, dadurch gekennzeichnet, daß von Zeit zu Zeit kurzzeitig die invertierte höchstwertige Binärstelle des Ausgangssignals des Aufwärts/Abwärts-Zählers (6) anstelle des Binärsignals einem Steuereingang des Aufwärts/Abwärts-Zählers (6) zugeführt wird.

9. Schaltungsanordnung nach Anspruch 7, dadurch gekennzeichnet, daß die Wiederholfrequenz, mit welcher der Aufwärts/Abwärts-Zähler (6) in Richtung auf die Mitte des Wertebereichs gesteuert wird, vom Ausgangssignal des Aufwärts/Abwärts-Zählers (6) abhängig ist.

10. Schaltungsanordnung nach Anspruch 9, dadurch gekennzeichnet, daß zur Steuerung der Wiederholfrequenz mehrere, vorzugsweise zwei, der höchstwertigen Binärstellen des Ausgangssignals des Aufwärts/Abwärts-Zählers (6) verwendet werden.

11. Schaltungsanordnung nach Anspruch 1, dadurch gekennzeichnet, daß die Schwellwertschaltung von einem an sich für digitale Signale vorgesehenen Invertierer (3) gebildet wird.

Fig. 1

Fig. 2

6

Fig. 3

Fig. 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | IBM TECHNICAL DISCLOSURE BULLETIN. Bd. 16, Nr. 1, Juni 1973, NEW YORK US Seiten 273 - 274; ROTH ET AL.: 'SELF ADJUSTABLE WAVEFORM SQUARING CIRCUIT' | 1,11 | H03K5/08 |
| A | * das ganze Dokument * --- | 2,7 | |
| X | PATENT ABSTRACTS OF JAPAN vol. 6, no. 37 (E-97)(915) 6. März 1982 & JP-A-56 157 124 ( TOKYO SHIBAURA DENKI KABUSHIKI KAISHA ) 4. Dezember 1981 * das ganze Dokument * * Zusammenfassung * --- | 1 | |
| A | US-A-4 929 851 (PACE) ----- | | |

| RECHERCHIERTE SACHGEBIETE (Int. Cl.5) |
|---|
| H03K G01R |

Der vorliegende Recherchenbericht wurde für alle Patentansprüche erstellt

| Recherchenort | Abschlußdatum der Recherche | Prüfer |
|---|---|---|
| DEN HAAG | 06 MAI 1992 | SEGAERT P.A.O.M.P. |